# EUROPÄISCHE PATENTANMELDUNG

(11) **EP 2 806 279 A1**
(43) Veröffentlichungstag der Anmeldung: **26.11.2014**
(21) Anmeldenummer: 14000434.2
(22) Anmeldetag: 06.02.2014
(51) Int. Cl.: G01R 31/02, G01R 31/08, G01R 31/12

(54) **Messverfahren mit einer Messvorrichtung zur Kabeldiagnose und/oder zur Kabelprüfung**

(30) Priorität: 22.05.2013 DE 102013008968
(71) Anmelder: Hagenuk KMT Kabelmesstechnik GmbH, 01471 Radeburg (DE)
(72) Erfinder: Scheuschner, Sven, 01471 Radeburg (DE); Berth, Torsten, 01468 Moritzburg (DE); Petzold, Frank, 96148 Baunach (DE)
(74) Vertreter: Hansmann, Dierk

(57) **Zusammenfassung**

Es wird ein Messverfahren zur Kabeldiagnose und/oder zur Kabelprüfung mit einer Signalaufprägeeinrichtung vorgeschlagen, welche eine niederfrequente Wechselspannungssignalfolge mit einem niederfrequenten Prüfsignal und einem darauf folgendem niederfrequenten Diagnosesignal erzeugt, wobei das niederfrequente Diagnosesignal eine gedämpfte Schwingung darstellt.

Somit erfolgt mittels einer Signalaufprägeeinrichtung sowohl eine Kabelprüfung als auch eine Kabeldiagnose. Hierbei wird durch das Verwenden eines gedämpften Diagnosesignals eine besonders schonende und effektive Messmethode bereitgestellt.

## Beschreibung

Die Erfindung betrifft ein Messverfahren mit einer Messvorrichtung zur Kabeldiagnose und/oder zur Kabelprüfung mit einer Signalaufprägeeinrichtung, welche eine niederfrequente Wechselspannungssignalfolge mit einem niederfrequenten Prüfsignal und einem darauf folgendem niederfrequenten Diagnosesignal erzeugt.

Das Bestimmen der elektrischen Eigenschaften eines Kabels ist wichtiger Bestandteil, um den störungsfreien Netzbetrieb mit der Kabelanlage zu gewährleisten.

Zum einen kann das Kabel auf Kabelmantelschäden geprüft werden und es kann die Hauptisolation (Aderisolation) einer Spannungsprüfung unterzogen werden (sogenannte Kabelprüfung). Zum anderen können Kabeleigenschaften wie die Kapazität und Polarisationseigenschaften, welche Indikatoren von Alterungsprozessen darstellen, bestimmt und das Kabel zusätzlich auf Teilentladungen untersucht werden (sogenannte Kabeldiagnose).

Grundsätzlich werden die Kabelprüfung und die Kabeldiagnose mit unterschiedlichen Geräten und auf unterschiedlichen Wegen durchgeführt.

Bei der Kabeldiagnose wird der Prüfling, wie ein Mittelspannungskabel, üblicherweise linear mit einer Spannung aufgeladen und anschließend mittels einer gedämpften Spannung abgefragt.

Bei gattungsgemäßen Messvorrichtungen erfolgt die Prüfmessung mittels einer Very-Low-Frequency (VLF) Prüftechnik. Zu den Grundlagen der VLF-Technik wird auf DE 44 13 585 C2 und DE 44 37 355 C2 verwiesen, deren diesbezüglicher Inhalt Bestandteil vorliegender Anmeldung ist.

Einen sehr guten Überblick und die technischen Grundlagen eines OWTS (Oscillating Wave Test System) zur Kabeldiagnose können der Schrift "Transmission Power Cables PD Detection at Damped AC Voltages" von Gulski et al. (JICABLE'03-International Conference on Insulated Power Cables) entnommen werden.

Bei Techniken des Standes der Technik, insbesondere bei der OWTS-Technik zur Kabeldiagnose, werden Kabel unipolar mit Gleichspannung beaufschlagt.

Hierbei wird die Dauer der Gleichspannungsbelastung durch die Leistung bzw. dem Ausgangsstrom der Hochspannungsquelle in Verbindung mit der zu Prüfenden Kabelkapazität, somit der Kabellänge, bestimmt.

Insbesondere bei sehr langen Kabeln führt dieses Systembedingt zu einer sehr langen nicht akzeptablen Gleichspannungsbelastung bis zu mehreren Minuten.

Diese Vorgehensweise kann das Kabel z.B. aufgrund von Polarisationseffekten d. h. Raumladungsbildung schädigen. Zudem können Prüfung und Diagnose nicht mittels eines Verfahrens durchgeführt werden, sondern es sind mehrere Messvorrichtungen für ein Messverfahren notwendig.

Aufgabe der Erfindung ist es, ein gattungsgemäßes Verfahren zu verbessern und ein Verfahren mit einer Kombination von Prüf- und Diagnosesignal zu ermöglichen,

Die Lösung der Aufgabe erfolgt erfindungsgemäß, dadurch gekennzeichnet, dass eine Sollspannung mittels einer Wechselspannung einstellbar ist und sich eine gedämpfte Schwingung als Diagnosesignal anschließt, wobei das niederfrequente Prüfsignal und/oder das niederfrequente Diagnosesignal bipolar ausgeführt ist.

Somit kann mittels einer Signalaufprägeeinrichtung sowohl eine Kabelprüfung als auch eine Kabeldiagnose erfolgen. Zudem kann durch das Verwenden eines gedämpften Diagnosesignals eine besonders schonende und effektive Messmethode bereitgestellt werden.

Durch das Verwenden einer Wechselspannungsfolge wird eine Belastung des Kabels verhindert und ein sanftes bipolares Anfahren der Prüfspannung ermöglicht.

Zudem ermöglicht das Verwenden eines niederfrequenten Prüfsignals über eine Prüfzeit eine Erkennung von thermischen Effekten.

Weitere vorteilhafte Ausbildungen des Messverfahrens sind durch die Merkmale der Ansprüche 2 bis 4 gekennzeichnet.

Folgendes Begriffliche sei erläutert:

Als "Kabelprüfung" wird insbesondere ein Verfahren zur Bestimmung einer Funktionsfähigkeit eines Kabels verstanden. Hierbei wird die Funktionsfähigkeit des Kabels über eine vorgegebene Prüfzeit mit einer vorgegebenen Prüfspannungshöhe ermittelt. Erfindungsgemäß kann insbesondere für die Kabelprüfung die VLF-Prüftechnik angewendet werden.

Die vorgegebene Prüfzeit ist als ein Zeitraum zu verstehen, der in entsprechenden technischen Regelwerken, für die Kabelprüfung vorgegeben ist. Insbesondere kann die Prüfzeit für eine Kabelprüfung eines Mittelspannungskabels mittels der VLF-Prüftechnik zwischen 30 Minuten und 60 Minuten betragen. Dadurch können zum Bestimmen der Funktionsfähigkeit des Kabels auch thermische Effekte im Kabel berücksichtigt werden.

Unter einer "Kabeldiagnose" wird insbesondere ein Verfahren zur Bestimmung eines momentanen Zustandes, insbesondere eines Alterungszustandes, des Kabels während einer Diagnosezeit verstanden. Insbesondere kann die OWTS-Technik zur Kabeldiagnose eingesetzt werden. Zum Bestimmen des Zustandes des Kabels können auch mehrere einzelne Messverfahren kombiniert werden. Insbesondere können eine tan-Delta-Messung und eine Teilentladungsmessung für die Kabeldiagnose kombiniert werden.

Als Diagnosezeit ist ein frei wählbarer Zeitraum anzusehen, in welchem ein Diagnosesignal an dem Kabel anliegt. Die Diagnosezeit ist deutlich kürzer als die Prüfzeit und kann insbesondere zwischen 1 Sekunde und 5 Minuten liegen.

Unter einer "Signalaufprägeeinrichtung" wird insbesondere eine Vorrichtung verstanden, welche ein elektrisches Signal aus einer elektrischen Energiequelle für die Kabelprüfung und/oder die Kabeldiagnose aufbereitet und mit dem aufbereiteten elektrischen Signal das Kabel speist und/oder beaufschlagt.

Als "niederfrequent" kann ein Signal, insbesondere ein elektrisches Signal, angesehen werden, dessen wesentliche spektrale Signalanteile jeweils eine Frequenz von kleiner als 20 Kilohertz aufweisen. Das Signal setzt sich hierbei insbesondere aus einer oder mehreren Sinusschwingungen einer oder mehrerer Frequenzen zusammen. Eine oder mehrere Sinusschwingungen einer Frequenz bilden dabei den spektralen Signalanteil zu dieser Frequenz. Insbesondere kann ein Rechtecksignal mit einer Frequenz von 500 Hertz oder weniger als niederfrequent angesehen werden.

Unter wesentlichen spektralen Signalanteilen werden insbesondere die spektralen Signalanteile verstanden, deren spektrale Leistungsdichte mindestens 10 vom Hundert der spektralen Leistungsdichte des Signalanteiles mit der maximalen spektralen Leistungsdichte betragen.

Als "Wechselspannungssignalfolge" ist eine Aneinanderreihung mehrerer elektrischer Signale zu verstehen, deren elektrische Spannung alternierend ihre Polarität wechselt.

Unter einem "Prüfsignal" wird ein elektrisches Signal zur Kabelprüfung verstanden.

Als "Diagnosesignal" ist ein elektrisches Signal zur Kabeldiagnose zu verstehen.

Um ein realitätsnahes Messergebnis zu erhalten, kann das niederfrequente Prüfsignal und/oder das niederfrequente Diagnosesignal eine Signalflanke aufweisen, welche einer Netzsignalflanke entspricht.

Unter einer "Signalflanke" wird insbesondere bei einem rechteckförmigen Signal ein zeitlicher Signalabschnitt verstanden, in dem das Signal von 10 vom Hundert seines Spitze-Spitze-Wertes auf 90 vom Hundert seines Spitze-Spitze-Wertes ansteigt (steigende Flanke) oder von 90 vom Hundert seines Spitze-Spitze-Wertes auf 10 vom Hundert seines Spitze-Spitze-Wertes abfällt (fallende Flanke). Insbesondere bei einem sinusförmigen Signal wird unter der Signalflanke eine Steigung im Wendepunkt verstanden.

Als "Netzsignalflanke" ist die Flanke eines elektrischen Signales anzusehen, mit welchem das Kabel zur elektrischen Energieversorgung von Verbrauchern in einem Energieversorgungsnetz gespeist wurde und/oder werden soll. Insbesondere kann eine Netzsignalflanke die Steigung im Nulldurchgang einer Wechselspannung mit einer Frequenz von 50 Hertz sein.

Unter "entsprechen" wird verstanden, dass Abweichungen und/oder Unterschiede maximal 30 vom Hundert betragen. Günstig ist es, wenn die Abweichungen und/oder Unterschiede maximal 10 vom Hundert betragen. Besonders günstig ist es, wenn die Abweichungen und/oder Unterschiede maximal 5 vom Hundert betragen.

In einer weiteren Ausführungsform steigt das Prüfsignal an.

Somit kann eine ansteigende Belastung und/oder Prüfung des Kabels erreicht und eine sprunghafte und/oder impulsartige Belastung verhindert werden. Insbesondere kann das Prüfsignal kontinuierlich oder schrittweise ansteigen.

In einer weiteren Ausführungsform folgen der Wechselspannungssignalfolge weitere Wechselspannungssignale. Hierdurch lassen sich besonders einfach und effizient mehrere Kabelprüfungen und/oder Kabeldiagnose ohne Zeitverlust nacheinander durchführen. Gleichzeitig können dadurch eine statistische Aussage über die Ergebnisse der Kabelprüfung und/oder Kabeldiagnose getroffen und somit Messfehler minimiert werden.

In einer weiteren Ausgestaltung der Messvorrichtung weist das Diagnosesignal eine Diagnoseanfangsspannung auf, welche einem Minimalwert einer negativen Periode einer Prüfsignalspannung, einem Maximalwert einer positiven Periode der Prüfsignalspannung oder einem Zwischenspannungswert der Prüfsignalspannung entsprechen kann. D. h. das Diagnosesignal schließt sich kontinuierlich dem Prüfsignal an.

Hierdurch werden Spannungssprünge und/oder Spannungsspitzen im Übergang zwischen Prüfsignal und Diagnosesignal vermieden. Ferner kann ein Risiko einer unerwünschten Belastung und/oder einer Schädigung des Kabels reduziert werden.

Die Signalaufprägeeinrichtung der Messvorrichtung weist in einer weiteren Ausführungsform der Erfindung ein elektronisches Schaltelement, insbesondere einen Thyristor, auf, welcher insbesondere bei einem Erzeugen des niederfrequenten Diagnosesignals kontinuierlich betrieben wird.

Durch das Verwenden des elektronischen Schaltelementes, insbesondere des Thyristors, können eine kompakte und verschleißarme Bauweise der Messvorrichtung realisiert und Schaltzeiten besonders kurz gehalten werden. Durch ein kontinuierliches Betreiben des Thyristors beim Erzeugen des niederfrequenten Diagnosesignals kann ein ununterbrochenes und gleichmäßiges Diagnosesignal erzeugt werden. Dadurch kann das Risiko einer unerwünschten Belastung und/oder einer Schädigung des Kabels reduziert werden.

Im Weiteren wird die Erfindung anhand von Ausführungsbeispielen erläutert. Es zeigen:
- Figur 1: eine schematische Darstellung eines Messsystems mit einer Messvorrichtung mit einer Signalaufprägeeinrichtung, einer elektrischen Energiequelle und einem Kabel und
- Figur 2: einen schematischen Verlauf einer niederfrequenten Wechselspannungssignalfolge mit einem niederfrequenten Prüfsignal und einem darauf folgenden niederfrequenten gedämpften Diagnosesignal.

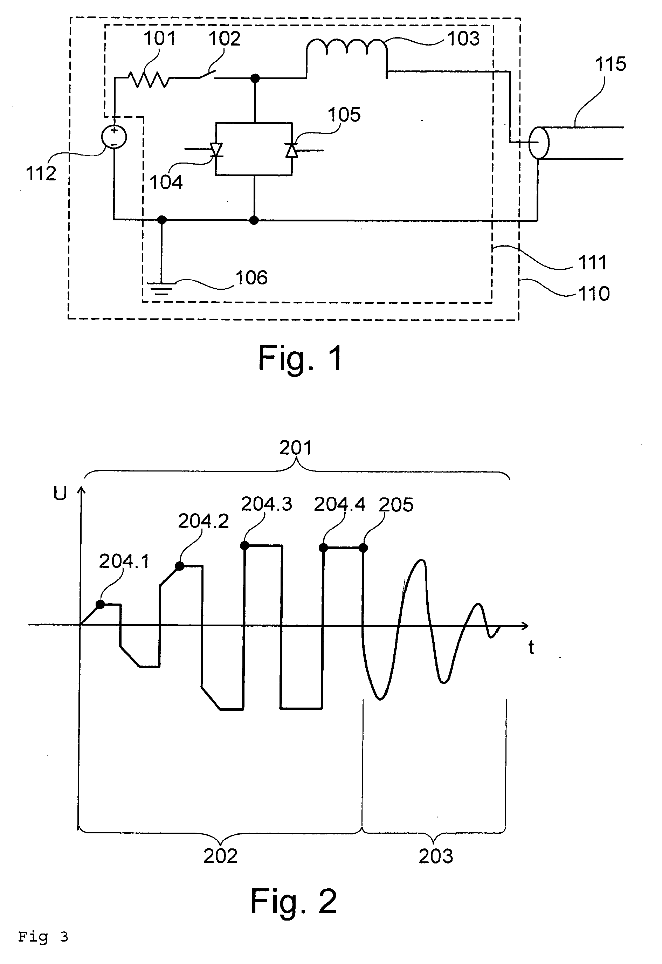

Das in Fig. 1 dargestellte Messsystem umfasst die Messvorrichtung 110 und als Prüfling das Kabel 115. Teil der Messvorrichtung 110 ist die Signalaufprägeeinrichtung 111 und die elektrische Energiequelle 112.

Die Signalaufprägeeinrichtung 111 umfasst einen elektrischen Widerstand 101 mit einem in Reihe geschalteten Schalter 102. Ferner weist die Signalaufprägeeinrichtung 111 eine Drossel 103 sowie einen ersten Thyristor 104 und einen zweiten Thyristor 105 auf. Hierbei sind die Thyristoren 104 und 105 in serie zu der Drossel 103 geschaltet.

Die Drossel 103 der Signalaufprägeeinrichtung 111 ist mit einem Innenleiter des Kabels 115 verbunden. Ein Mantel des Kabels 115 ist mit einer elektrischen Masse 106 verbunden. Ebenfalls mit der elektrischen Masse 106 sind die Thyristoren 104 und 105 sowie die elektrische Energiequelle 112 verbunden.

In Figur 2 ist der zeitliche Verlauf der niederfrequenten Wechselspannungsfolge 201 mit dem Prüfsignal 202 und dem darauffolgenden gedämpften Diagnosesignal 203 dargestellt. Die Maximalspannung des Prüfsignales 202 wird über mehrere Zwischenspannungswerte 204.1, 204.2, 204.3 aufgebaut. Das Diagnosesignal 203 beginnt mit einer Diagnoseanfangsspannung 205.

Um das Kabel 115 zu prüfen und insbesondere eine sogenannte Einsetzspannung und eine sogenannte Aussetzspannung einer Teilentladung zu erfassen, wird während der Kabelprüfung die Spannung des Prüfsignals 202 in definierten Schritten bis zum Einsetzen der Teilentladung erhöht. Liegt die maximale Spannung des Prüfsignals 202 unterhalb der Einsetzspannung der Teilentladung, wird diese Einsetzspannung nicht erfasst.

Alternativ ist dies nicht zwingend vorgesehen, da bei einer nicht vorhandenen Teilentladung innerhalb des Prüfsignals 202 das Kabel 115 als voll funktionsfähig angesehen wird.

Zum Aufladen des Kabels 115 der Schalter 102 geschlossen und das Kabel 115 mittels der elektrischen Energiequelle 112 auf einen Zwischenspannungswert 204.1 des Prüfsignals 202 aufgeladen. Hierbei sind die Thyristoren 104 und 105 geöffnet. Alternativ zu den Thyristoren 104 und 105 können auch mit Dioden gekoppelte mechanische Schalter verwendet werden.

Beim Aufladen des Kabels 115 fließt ein elektrischer Strom aus der elektrischen Energiequelle 112 über den Widerstand 101 und die Drossel 103 zum Innenleiter des Kabels 115. Der Innenleiter des Kabels 115 bildet zusammen mit dem Mantel des Kabels 115 eine Kapazität, die von der Länge des Kabels 115 abhängt.

Die elektrische Energiequelle 112 ist als Gleichspannungsquelle ausgestaltet und der Widerstand 101 dient der elektrischen Energiequelle 112 als Schutz gegen rücklaufende Wanderwellen und als Schutz vor Überlastung.

Ist das Kabel 115 auf den Zwischenspannungswert 204.1 des Prüfsignals 202 aufgeladen, wird der Schalter 102 geöffnet und somit der Stromfluss aus der elektrischen Energiequelle 112 unterbrochen. Der erste Thyristor 104 wird geschlossen, was zu einem Umschwingen des Prüfsignales 202 führt.

Im Anschluss daran wird der zweite Thyristor 105 geschlossen, wodurch das Prüfsignal 202 zurückschwingt.

Um das Kabel 115 auf einen höheren Zwischenspannungswert 204.2 des Prüfsignals 202 aufzuladen, wird der Schalter 102 wieder geschlossen. Der zuvor beschriebene Vorgang wird so oft wiederholt, bis eine Sollspannung des Prüfsignales 202 erreicht ist.

Alternativ kann der Vorgang solange wiederholt werden, bis eine Sollspannung des Diagnosesignales 203 erreicht ist. Ist die Sollspannnung und damit eine Diagnoseanfangsspannung 205 erreicht, werden beide Thyristoren 104 und 105 geschlossen. Damit wird das Diagnosesignal 203 erzeugt und die Kabeldiagnose wird durchgeführt.

Die Kapazität des Kabels 115 bildet nun zusammen mit der Drossel 103 über die geschlossenen Thyristoren 104 und 105 einen Reihenschwingkreis. Es ergibt sich eine gedämpfte Schwingung des Diagnosesignales 203, wobei die Schwingungsfrequenz bestimmt wird durch die Drossel 103 und die Kapazität des Kabels 115.

Anhand der Schwingungsfrequenz des Diagnosesignales 203 wird die Kapazität des Kabels 115 bestimmt. Anhand des Verlaufes und einem Abklingverhalten des Diagnosesignales 203 werden insbesondere der Verlustfaktor tan delta und weitere Kabeleigenschaften bestimmt.

Nach Abklingen der gedämpften Schwingung des Diagnosesignales 203 wird das Aufladen des Kabels 115 mittels des Prüfsignales 202 erneut gestartet.

## Patentansprüche

1. Messverfahren mit einer Messvorrichtung zur Kabeldiagnose und/oder zur Kabelprüfung mit einer Signalaufprägeeinrichtung, welche eine niederfrequente Wechselspannungssignalfolge mit einem niederfrequenten Prüfsignal und einem darauf folgendem niederfrequenten Diagnosesignal erzeugt, **dadurch gekennzeichnet, dass** eine Sollspannung mittels einer Wechselspannung einstellbar ist und sich eine gedämpfte Schwingung als Diagnosesignal anschließt, wobei das niederfrequente Prüfsignal und/oder das niederfrequente Diagnosesignal bipolar ausgeführt ist.

2. Messverfahren nach Anspruch 1, **dadurch gekennzeichnet, dass** das Prüfsignal ansteigt.

3. Messverfahren nach Anspruch 1 oder 2, **dadurch gekennzeichnet, dass** weitere Diagnosesignalfolgen der Wechselspannungssignalfolge folgen.

4. Messverfahren nach einem der Ansprüche 1 bis 3, **dadurch gekennzeichnet, dass** die Signalaufprägeeinrichutng ein elektronisches Schaltelement, insbesondere einen Thyristor, aufweist, welcher beim Erzeugen des niederfrequenten Diagnosesignals kontinuierlich betrieben wird.
